Europäisches Patentamt

European Patent Office

Office européen des brevets

(19)

(11) **EP 0 407 591 B1**

(12) **EUROPEAN PATENT SPECIFICATION**

(45) Date of publication and mention
of the grant of the patent:
**21.08.1996 Bulletin 1996/34**

(21) Application number: **89911109.0**

(22) Date of filing: **06.10.1989**

(51) Int Cl.6: **H03K 5/02**, H03K 3/356,
G11C 7/06

(86) International application number:
**PCT/JP89/01029**

(87) International publication number:
**WO 90/04286 (19.04.1990 Gazette 1990/09)**

(54) **DIFFERENTIAL AMPLIFIER CIRCUIT**

SCHALTUNG FÜR EINEN DIFFERENTIELLEN KREISVERSTÄRKER

CIRCUIT AMPLIFICATEUR DIFFERENTIEL

(84) Designated Contracting States:
**DE FR GB**

(30) Priority: **11.10.1988 JP 255542/88**

(43) Date of publication of application:
**16.01.1991 Bulletin 1991/03**

(73) Proprietor: **Oki Electric Industry Co., Ltd.
Tokyo (JP)**

(72) Inventors:
• **MIYAMOTO, Sanpei
Oki Electric Industry Co., Ltd.
Tokyo 105 (JP)**

• **UEHARA, Hidenori Oki Electric Industry Co., Ltd.
Tokyo 105 (JP)**

(74) Representative: **Betten, Jürgen, Dipl.-Ing. et al
Betten & Resch Patentanwälte
Reichenbachstrasse 19
80469 München (DE)**

(56) References cited:
EP-A- 0 061 844          EP-A- 0 180 193
JP-A-58 179 990          US-A- 4 561 702
US-A- 4 910 713

# Description

SPECIFICATION

## TECHNICAL FIELD

The present invention relates to a differential amplifier operable dynamically for differentially amplifying two input signals in response to an active signal.

## BACKGROUND ART

The differential amplifier is employed in various purposes such as sharing of a logical level "H" or "L". An example of sharing of the logical level is ① an address buffer of a semiconductor memory for converting an input "H" level 2.4 V and "L" level 0.8 V of a transistor-transistor logic (TTL) into "H" level 5 V and "L" level 0 V of a MOS logical level or ② a sense amplifier for detecting that a signal stored in the semiconductor memory is "H" level or "L" level.

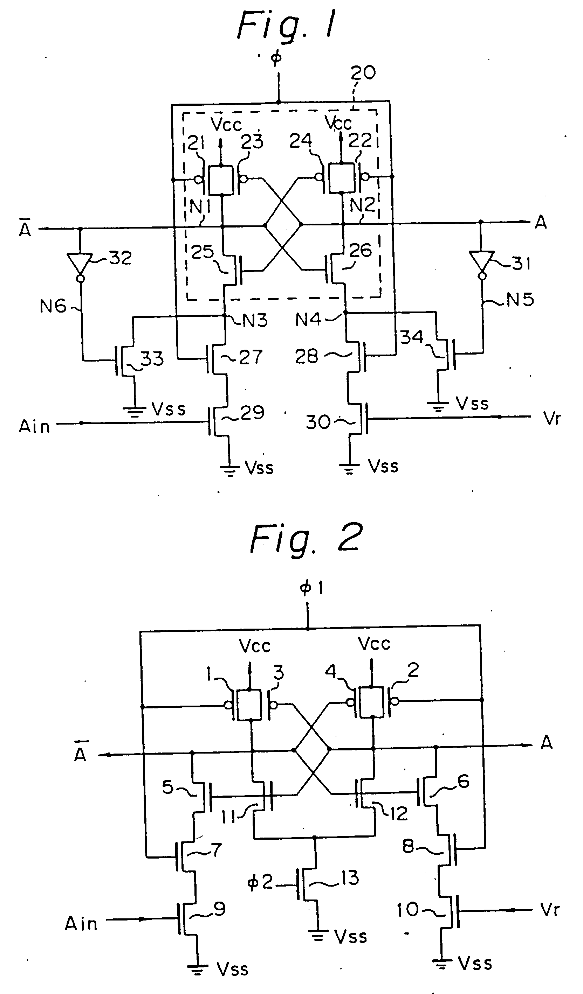

An arrangement of a conventional differential amplifier in case of ① is exemplarily illustrated in Fig. 2.

The differential amplifier differentiates potentials between a first input signal $A_{in}$ (e.g. 2.4 V or 0.8 V) and a second input signal $V_r$ (e.g. 1.5 V) in response to an "H" level of an active signal $\phi 1$ and holds a differentially determined value in response to an "H" level of a latch signal $\phi 2$ and outputs complementary output signals A, $\overline{A}$ (e.g. 5 V or 0 V), which comprises P-channel field effect transistors (hereinafter referred to as FET) 1 to 4 and N-channel FETs 5 to 13. Designated at $V_{CC}$ in Fig. 2 is a power supply potential (first potential) and $V_{SS}$ is a ground potential (second potential).

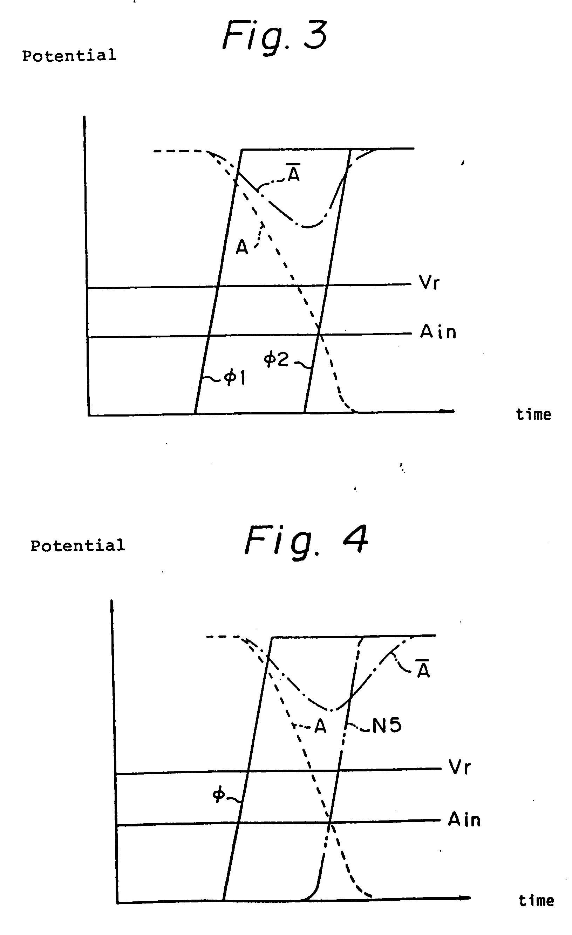

Fig. 3 is a waveform showing an operation of the differential amplifier of Fig. 2. The operation of the differential amplifier of Fig. 2 will be described with reference to this figure.

The active signal $\phi 1$ and the latch signal $\phi 2$ are at first respectively at "L" level (=$V_{SS}$ level) and the output signals A, $\overline{A}$ are respectively precharged into the power supply potential $V_{CC}$ by way of FETs 1 and 2.

When the active signal $\phi 1$ goes "H" level, the FETs 7 and 8 are turned on so that the output signal $\overline{A}$ is discharged by way of the FETs 5, 7 and 9 and the output signal A is discharged by way of the FETs 6, 8 and 10. Assuming that the input signal $A_{in}$ is 0.8 V and the input signal $V_r$ is 1.5 V, a conductance of the FET 10 having a gate to which the input signal $V_r$ is applied is greater than that of the FET 9 having a gate to which the input signal $A_{in}$ is applied. Hence, the output signal $\overline{A}$ is discharged more rapidly than the output signal A so that the potential of the output signal $\overline{A}$ is lower than that of the output signal A. If there generates a potential difference between the output signals A and $\overline{A}$, there generates a conductance difference between the FETs 5 and 6. If the potential of the output signal A is lower than $V_{CC}$ - $V_{tp}$, (where $V_{tp}$ is a threshold voltage of the P-channel FET), the FET 3 is turned on through which the output signal $\overline{A}$ starts charging at the side of the power supply potential $V_{CC}$ so that the potential difference between the output signals A and $\overline{A}$ is further increased.

When the latch signal $\phi 2$ goes "H" level (=$V_{CC}$ level), the FET 13 is turned on and at the same time the output signal A goes the ground potential $V_{SS}$ level and the output signal $\overline{A}$ goes the power supply potential $V_{CC}$ level whereby the output signal A is clamped to the ground potential $V_{SS}$ by way of FETs 12 and 13 and the output signal $\overline{A}$ is clamped to the power supply potential and the output signal $\overline{A}$ is clampe to the power supply potential $V_{CC}$ by way of the FET 3. After completion of the clamping, the output signals A and $\overline{A}$ are kept held at the ground potential $V_{SS}$ and the power supply potential $V_{CC}$ irrespective of the change of the potentials of the input signals $A_{in}$ and $V_r$.

The conventional differencial amplifier requires two control signals, namely, the active signal $\phi 1$ and the latch signal $\phi 2$ and further requires timing controls for delaying the active signal $\phi 1$ and the latch signal $\phi 2$. The conventional amplifier was liable to cause erroneous operation when the delay time of the signals $\phi 1$ and $\phi 2$ is so short since the latch signal $\phi 2$ rises at "H" level at the state where the potential difference between the output signals A and $\overline{A}$ is not substantially assured. On the contrary, the conventional amplifier was liable to cause an operation speed to delay when the delay time of the signals $\phi 1$ and $\phi 2$ is so long, since it takes long time until the output signals are latched so that the output signals may be maintained long at the levels of the input signals $A_{in}$ and $V_r$.

In the U.S. Patent 4 910 713 a CMOS differential amplifier having a single strobing input and comprising a flip-flop is disclosed. It lacks, however, a means for clamping the output signals to their respective levels irrespective of the change of the potentials of the input signals.

It is object of the present invention to provide a differential amplifier capable of causing less erroneous operation and to provide a clamping means for the output signals as described above.

## DISCLOSURE OF THE INVENTION

A differential amplifier according to the present invention is disclosed in claim 1. Further embodiments of the present invention are disclosed in claims 2 to 23.

## BRIEF DESCRIPTION OF THE DRAWINGS

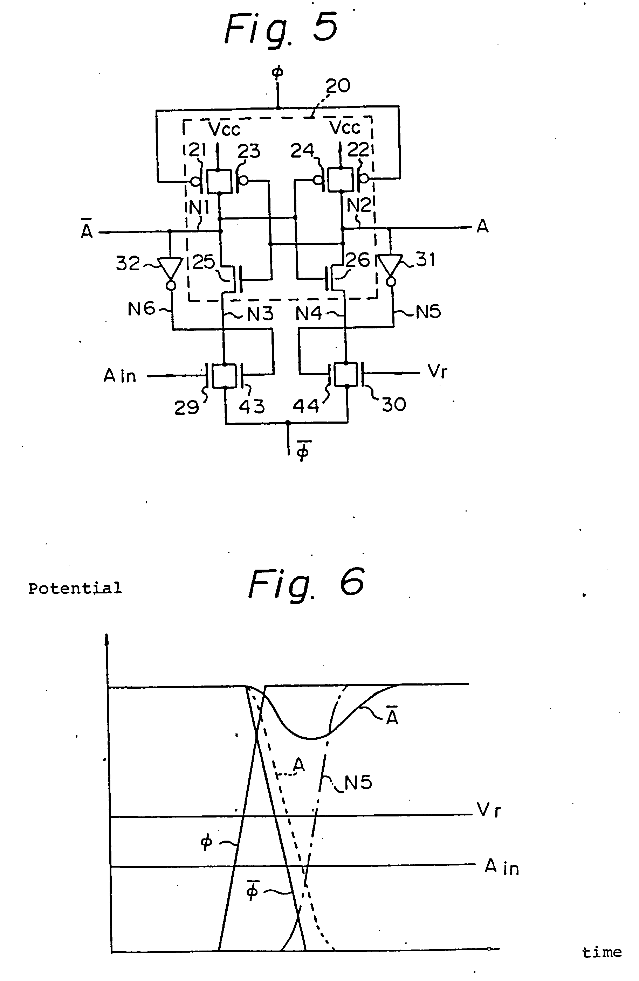

Fig. 1 is a circuit diagram showing a differential amplifier according to a first embodiment of the present invention, Fig. 2 is a circuit diagram showing a conventional differential amplifier, Fig. 3 is a waveform showing an operation of Fig. 2, Fig. 4 is a waveform showing an operation of Fig. 1, Fig. 5 is a circuit diagram showing a differential amplifier according to a second embodiment of the present invention and Fig. 6 is a waveform showing an operation of Fig. 5.

BEST MODE FOR CARRYING OUT THE INVENTION

The present invention will be described more in detail with reference to Fig. 1 and Figs. 4 to 6.

Fig. 1 is a circuit diagram of a differential amplifier of a dynamic type according to the first embodiment of the present invention. The differential amplifier detects a potential difference between a first input signal $A_{in}$ (e. g. 2.4 V or 0.8 V) and a second input signal $V_r$ (e.g. 1.5 V) in response to an "H" level of an active signal $\phi$ and provides complementary fixed output signals A, $\overline{A}$ (e.g. 5 V and 0 V) on the basis of the different magnitudes or values between the first input signal $A_{in}$ and the second input signal $V_r$. The differential amplifier comprises a flip-flop circuit 20 (hereinafter referred to as FF circuit), N-channel transistors 27 to 30, 33, 34 and inverters 31, 32. The FF circuit 20 has a P-channel FETs 21 to 24 and N-channel FETs 25, 26 in which sources of the parallel connected P-channel FETs 21, 23 are commonly connected to a power supply potential $V_{CC}$ as a first potential and drains thereof are commonly connected to a first output node N1. A drain of the N-channel FET 25 is connected to the first output node N1 and a source of the N-channel FET 25 is connected to a first node N3. Similarly, the P-channel FETs 22, 24 are connected in parallel between the power supply potential $V_{CC}$ and a second output node N2 and the N-channel FET 26 is connected between the second output node N2 and a second node N4. A gate of the P-channel FET 23 and a gate of the N-channel FET 25 are commonly connected to the second output node N2 and a gate of the P-channel FET 24 and a gate of the N-channel FET 26 are commonly connected to the first output node N1. The active signal $\phi$ is commonly applied to gates of the P-channel FETs 21, 22. Drains of the N-channel FETs 27, 28 are connected to the first and the second nodes N3, N4 and the active signal $\phi$ is applied to gates of the FETs 27, 28. Sources of the N-channel FETs 27, 28 are connected to drains of the FETs 29, 30 and sources of the FETs 29, 30 are respectively connected to the ground potential $V_{SS}$ as the second potential. Drains of N-channel FETs 33, 34 are connected to the first and the second nodes N3, N4 and sources of the FETs 33, 34 are respectively connected to the ground potential $V_{SS}$. Gates of the FETs 33, 34 are connected to outputs of inverters 32, 31. Inputs of the inverters 32, 31 are connected to the first and the second outputs nodes N1, N2. The output signals A, $\overline{A}$ are applied to the outputs nodes N1, N2. The input signals $A_{in}$, $V_r$ are applied to gates of the N-channel FETs 29, 30. A potential setting means comprises the inverter 31, the FET 34 and the inverter 32, the FET 33.

An operation of the differential amplifier according to the first embodiment will be described with reference to the waveform of an operation as illustrated in Fig. 4.

The active signal $\phi$ is at first at "L" level (=$V_{SS}$ level), hence the FETs 21, 22 are turned on. Accordingly, the output signals A, $\overline{A}$ are precharged to the power supply potential $V_{CC}$ by way of the FETs 21, 22.

When the active signal $\phi$ goes "H" level (=$V_{CC}$ level), the FETs 27, 28 are turned on so that the output signal $\overline{A}$ is discharged by way of the FETs 25, 27, 29 and at the same time the output signal A is discharged by way of the FETs 26, 28, 30. Assuming that the input signal $A_{in}$ is 0.8 V and the input signal $V_r$ is 1.5 V, the conductance of the FET 30 having the gate to which the input signal $V_r$ is applied is greater than the conductance of the FET 29 having the gate to which the input signal $A_{in}$ is applied. Accordingly, the output signal A is discharged more quickly than the output signals $\overline{A}$ so that the potential of the output signal A is lower than that of the output signal $\overline{A}$. Since there generates the potential difference between the output signals A, $\overline{A}$, there generates the conductance difference between the FETs 25, 26. When the potential of the output signal A is lower than $V_{CC}$ - $V_{tp}$, the FET 23 is turned on so that the output signal $\overline{A}$ starts charging to the power supply potential $V_{CC}$ by way of the FET 23 whereby the potential difference of the output signals A, $\overline{A}$ is more increased.

When the potential of the output signal A is reduced to be less than the threshold voltage of the inverter 31, a node N5 at the output side of the inverter 31 goes "H" level so that the FET 34 is turned on and the output signal A is clamped to the ground potential $V_{SS}$ by way of the FETs 26, 34. The FET 23 is turned on by the potential decrease of the output signal A so that the output signal $\overline{A}$ is clamped to the power supply potential $V_{CC}$ by way of the FET 23. At this state a node N6 at the output side of the inverter 32 is "L" level, hence the FET 33 is not turned on. After the output signals A, $\overline{A}$ are clamped, the output signals A, $\overline{A}$ are kept held at the potentials $V_{SS}$ level and the $V_{CC}$ level irrespective of the changes of the potentials.

Thereafter, when the active signal $\phi$ goes "L", the operation of the differential amplifier returns to the original state. When, 2.4 V (>$V_r$), for example, as the input signal $A_{in}$ is applied, the output signal A goes "H" level (=$V_{CC}$ level) and the output signal $\overline{A}$ goes "L" level (=$V_{SS}$ level) as set forth above.

It is preferable to set the threshold voltages of the inverters 31, 32 to be substantially a middle value between the first potential ($V_{CC}$) and the second potential. The reason is that if the threshold voltages of the inverters 31, 32 are close to the first potential ($V_{CC}$) there is a high possibility that the output signal is clamped by erroneous operation and if the threshold voltages are close to the second potential ($V_{SS}$) it takes long time to clamp the output signal.

The first embodiment has the following advantage.

Inasmuch as the latch control is effected by the inverse signals of the output signals A, $\overline{A}$ provided by the inverters 31, 32 an external latch signal is not necessitated and the differencial amplifier is operative only by

the active signal $\phi$. Therefor, it eliminates a timing control of the control signal which goes "H" level upon lapse of a predetermined time after the active signal $\phi$ goes "H" level so that the erroneous operation will be prevented and the differential amplification will be achieved at high speed.

A second embodiment of the present invention will be described with reference to Figs. 5 and 6. Fig. 5 is a circuit diagram showing a differential amplifier of the second embodiment of the present invention in which the elements same as those of Fig. 1 are designated at the same numerals and explanation thereof is omitted. In the differential amplifier, an inverse active signal $\bar{\phi}$ is employed instead of the ground potential $V_{SS}$ as the second potential in the first embodiment and the FETs 27, 28 are omitted. Furthermore, among the inverters 31, 32 and the FETs 33, 34 respectively constituting the potential setting means, N-channel FETs 43, 44 are connected in parallel to the FETs 29, 30 instead of the FETs 33, 34.

An operation of the differential amplifier according to the second embodiment will be described with reference to a waveform of an operation as illustrated in Fig. 6.

When the active signal $\phi$ goes "H" level from "L" level, the inverse active signal $\bar{\phi}$ goes "L" level from the "H" level so that the output signal A is discharged by way of the FETs 26, 30 and at the same time the output signal $\bar{A}$ is discharged by way of the FETs 25, 29. Assuming that the input signal $A_{in}$ is 0.8 V and the input signal $V_r$ is 1.5 V same as in the first embodiment, the conductance of the FET 30 is greater than that of the FET 29 so that the output signal A is discharged more quickly than the output signal $\bar{A}$ whereby the potential of the output signal A is lower than that of the output signal $\bar{A}$. Since there generates the potential difference between the output signals A, $\bar{A}$, there generates the conductance difference between the FETs 25, 26, hence the discharging speed between the output signals A, $\bar{A}$ is increased. When the potential of the output signal A is less than $V_{CC}$ - $V_{tp}$ ,
the FET 23 is turned on and the output signal $\bar{A}$ starts charging so that the potential difference between the output signals A, $\bar{A}$ is more increased. When the potential of the output signal A is reduced to be less than the threshold voltage of the inverter 31, the output thereof goes "H" level by the inverter 31 to thereby turn on the FET 44. Accordingly, the output signal A is clamped to "L" level and the output signal $\bar{A}$ is clamped to the ground potential $V_{CC}$.

According to the second embodiment set forth above, although the active signal $\phi$ and the inverse active signal $\bar{\phi}$ as two control signals are necessitated, the timing control in the signals having the inverse relationship can be effected with ease (e.g. can be made by one inverter) so that the potential difference can be reduced same as in the first embodiment. Furthermore, there is an advantage that two FETs are reduced according to the second embodiment compared with the first embodiment.

CAPABILITY OF EXPLOITATION IN INDUSTRY

As mentioned above in detail, inasmuch as the latch control can be effected when the output signal is less than a fixed potential according to the present invention, an external latch signal is unnecessitated which eliminates a minute timing control between the active signal and the latch signal. Accordingly, it is possible to stably differentiate the amplification without erroneous operation and with a simple control at high speed.

**Claims**

1. A differential amplifier comprising:

first (N1), second (N2), third (N3) and fourth (N4) nodes;
a first transistor (24) of a first conductivity type having a first control electrode coupled to the first node (N1), said first transistor (24) being coupled between the second node (N2) and a source of a first potential ($V_{CC}$);
a second transistor (23) of the first conductivity type having a second control electrode coupled to the second node (N2), the second transistor (23) being coupled between the first potential source ($V_{CC}$) and the first node (N1);
a third transistor (25) of a second conductivity type having a third control electrode coupled to the second node (N2), the third transistor (25) being coupled between the first node (N1) and the third node (N3);
a fourth transistor (26) of the second conductivity type having a fourth control electrode coupled to the first node (N1), the fourth transistor (26) being coupled between the second node (N2) and the fourth node (N4);
a first potential defining circuit, having a first input terminal ($A_{in}$) and being coupled to the third node (N3), for defining a potential of the first node (N1) in response to a signal applied to the first input terminal ($A_{in}$);
a second potential defining circuit, having a second input terminal ($V_r$) and being coupled to the fourth node (N4), for defining a potential of the second node (N2) in response to a signal applied to the second input terminal ($V_r$);
a fifth transistor (33; 43) having a fifth control electrode and being coupled to a source of a second potential ($V_{SS}$; $\bar{\phi}$) and to the third node (N3); and
a potential detecting circuit for detecting the potential of the first node (N1) and causing the fifth transistor (33; 43) to be conductive when the potential of the first node (N1) is less than a middle potential between the first potential ($V_{CC}$) and the second potential ($V_{SS}$; $\bar{\phi}$).

2. A differential amplifier according to claim 1 wherein the first transistor (24) and the second transistor (23) are p-channel FETs, and the third transistor (25) and the fourth transistor (26) are n-channel FETs.

3. A differential amplifier according to claim 1 wherein the first potential defining circuit comprises a sixth transistor (29) having a sixth control electrode coupled to the first input terminal ($A_{in}$), the sixth transistor (29) being coupled between the second potential source ($V_{SS}$; $\bar{\phi}$) and the third node (N3).

4. A differential amplifier according to claim 3 wherein the sixth transistor (29) is an n-channel FET.

5. A differential amplifier according to claim 3 wherein the second potential defining circuit comprises a seventh transistor (30) having a control electrode coupled to the second input terminal ($V_r$), and being coupled between the second potential source ($V_{SS}$; $\bar{\phi}$) and the fourth node (N4).

6. A differential amplifier according to claim 5 wherein said transistor (30) of said second potential defining circuit is an n-channel FET.

7. A differential amplifier according to claim 1 wherein said potential detecting circuit comprises an inverter (32) having an input terminal coupled to the first node (N1) and an output terminal coupled to the fifth control electrode.

8. A differential amplifier according to claim 5 further comprising:

    an eighth transistor (27) coupled between the third node (N3) and the sixth transistor (29) and having a control electrode to which an active signal ($\phi$) is applied; and
    a ninth transistor (28) coupled between the fourth node (N4) and the seventh transistor (30) and having a control electrode to which the active signal ($\phi$) is applied.

9. A differential amplifier according to claim 8 wherein said eighth (27) and ninth (28) transistors are n-channel FETs.

10. A differential amplifier according to claim 8 further comprising:

    a tenth transistor (21) coupled between the first potential source ($V_{CC}$) and the first node (N1), and having a control electrode to which the active signal ($\phi$) is applied; and
an eleventh transistor (22) coupled between the first potential source ($V_{CC}$) and the second node (N2), and having a control electrode to which the active signal ($\phi$) is applied.

11. A differential amplifier according to claim 10 wherein said tenth (21) and eleventh (22) transistors are p-channel FETs.

12. A differential amplifier according to claim 10 further comprising:

    a twelfth transistor (34; 44) having a control electrode and being coupled between said second potential source ($V_{SS}$; $\bar{\phi}$) and said fourth node (N4); and
    another potential detecting circuit for detecting the potential of the second node (N2) and causing said twelfth transistor (34; 44) to be conductive when the potential of the second node (N2) is less than the middle potential of the first potential ($V_{CC}$) and the second potential ($V_{SS}$; $\bar{\phi}$).

13. A differential amplifier according to claim 12 wherein said another potential defining circuit comprises an inverter (31) having an input terminal coupled to the second node and having an output terminal coupled to the control electrode of said twelfth transistor (34; 44).

14. A differential amplifier according to claim 1 for an integrated circuit, characterized in that said first (24) and second (23) transistors are cross-coupled p-channel transistors and said third (25) and fourth (26) transistors are cross-coupled n-channel transistors, each having a respective path of controllable conductivity and a control electrode and being part of a Flip-Flop (20), whereby first and second nodes within said flip flop are providing output signals from the differential amplifier.

15. The amplifier of claim 14 wherein said potential detecting circuit includes:

    an inverter (32) having an input coupled to said first node and
    an output coupled to the fifth control electrode.

16. The amplifier of claim 14 further comprising a second voltage detection circuit coupled to said second node (N2).

17. The amplifier of claim 14 further including:

    third (21) and fourth (22) p-channel transistors, the third p-channel transistor (21) coupled between said first potential source ($V_{CC}$) and the first node (N1), the fourth p-channel transistor (22) coupled between said first potential source and the second node (N2);
an input coupled to receive an active control signal ($\phi$), said input coupling said control signal to control electrodes of said third (21) and fourth (22) p-channel transistors.

18. The amplifier of claim 14 wherein the first potential defining circuit comprises a third n-channel transistor (29) having a control electrode coupled to the first input terminal ($A_{in}$) to which the first input signal is applied, and the second potential defining circuit comprises a fourth n-channel transistor (30) having a control electrode coupled to the second input terminal ($V_r$) to which the second input signal is applied.

19. The amplifier of claim 18 further comprising:

a fifth n-channel transistor (27) coupled between the third node (N3) and said first potential defining circuit and having a control electrode to which an active signal ($\phi$) is applied; and
a sixth n-channel transistor (28) coupled between the fourth node (N4) and said second potential defining circuit and having a control electrode to which the active signal ($\phi$) is applied.

20. A differential amplifier according to claim 1 characterizd in that

said transistors (23, 24, 25, 26) and a pair said of nodes (N1, N2) are part of a Flip-Flop (20);
a pair of output terminals ($\overline{A}$, A) is coupled to said nodes (N1, N2), respectively; and in that
a pull down circuit is responsively coupled between said potential detecting circuit and said flip flop (20).

21. The amplifier of claim 20 further including:
a precharge circuit having a pair of pull up transistors and configured to pull up a voltage potential on said nodes (N1, N2) in response to a control signal.

22. A differential amplifier according to claim 12 for an integrated circuit wherein
said potential detecting circuit comprises an inverter (32) having an input terminal coupled to said first node (N1) and an output terminal coupled to the fifth control electrode.

23. A differential amplifier according to claim 22 wherein said second potential detecting circuit comprises an inverter (31) having an input terminal coupled to the second node (N2) and having an output terminal coupled to the control electrode of said twelfth transistor (34; 44).

**Patentansprüche**

1. Differenzverstärker, der folgendes umfaßt:

einen ersten (N1), zweiten (N2), dritten (N3) und vierten (N4) Knotenpunkt;
einen ersten Transistor (24) eines ersten Leitfähigkeitstyps, der eine erste Steuerelektrode aufweist, die an den ersten Knotenpunkt (N1) gekoppelt ist, wobei der erste Transistor (24) zwischen den zweiten Knotenpunkt (N2) und einer ersten Potentialquelle ($V_{cc}$) geschaltet ist;
einen zweiten Transistor (23) des ersten Leitfähigkeittyps, der eine zweite Steuerelektrode aufweist, die an den zweiten Knotenpunkt (N2) gekoppelt ist, wobei der zweite Transistor (23) zwischen die erste Potentialquelle ($V_{cc}$) und den ersten Knotenpunkt (N1) geschaltet ist;
einen dritten Transistor (25) eines zweiten Leitfähigkeittyps, der eine dritte Steuerelektrode aufweist, die an den zweiten Knotenpunkt (N2) gekoppelt ist, wobei der dritte Transistor (25) zwischen den ersten Knotenpunkt (N1) und den dritten Knotenpunkt (N3) geschaltet ist;
einen vierten Transistor (26) des zweiten Leitfähigkeittyps, der eine vierte Steuerelektrode aufweist, die an den ersten Knotenpunkt (N1) gekoppelt ist, wobei der vierte Transistor (26) zwischen den zweiten Knotenpunkt (N2) und den vierten Knotenpunkt (N4) geschaltet ist;
eine erste Potentialfestlegungsschaltung, die eine erste Eingangsklemme ($A_{in}$) aufweist und an den dritten Knotenpunkt (N3) gekoppelt ist, um ein Potential des ersten Knotenpunkts (N1) in Reaktion auf ein Signal, das an der ersten Eingangsklemme ($A_{in}$) angelegt ist, festzulegen;
eine zweite Potentialfestlegungsschaltung, die eine zweite Eingangsklemme ($V_r$) aufweist und an den vierten Knotenpunkt (N4) gekoppelt ist, um ein Potential des zweiten Knotenpunkts (N2) in Reaktion auf ein Signal, das an der zweiten Eingangsklemme ($V_r$) angelegt ist, festzulegen;
einen fünften Transistor (33; 43), der eine fünfte Steuerelektrode aufweist und an eine zweite Potentialquelle ($V_{ss}; \overline{\emptyset}$) und an den dritten Knotenpunkt (N3) gekoppelt ist; und
eine Potentialermittlungsschaltung, um das Potential des ersten Knotenpunkts (N1) zu ermitteln und den fünften Transistor (33; 43) leitend zu machen, wenn das Potential des ersten Knotenpunkts (N1) kleiner ist als ein mittleres Potential zwischen dem ersten Potential (V$_{cc}$) und dem zweiten Potential (V$_{ss}$;$\overline{\varnothing}$).

2.   Differenzverstärker nach Anspruch 1, bei dem der erste Transistor (24) und der zweite Transistor (23) p-Kanal FETs sind, und der dritte Transistor (25) und der vierte Transistor (26) n-Kanal FETs sind.

3.   Differenzverstärker nach Anspruch 1, bei dem die erste Potentialfestlegungsschaltung einen sechsten Transistor (29) umfaßt, der eine sechste Steuerelektrode aufweist, die an die erste Eingangsklemme (A$_{in}$) gekoppelt ist, wobei der sechste Transistor (29) zwischen die zweite Potentialquelle (V$_{ss}$; $\overline{\varnothing}$ ) und den dritten Knotenpunkt (N3) geschaltet ist.

4.   Differenzverstärker nach Anspruch 3, bei dem der sechste Transistor (29) ein n-Kanal FET ist.

5.   Differenzverstärker nach Anspruch 3, bei dem die zweite Potentialfestlegungsschaltung einen siebten Transistor (30) umfaßt, der eine Steuerelektrode aufweist, die an die zweite Eingangsklemme (V$_r$) gekoppelt ist, und der zwischen die zweite Potentialquelle (V$_{ss}$;$\overline{\varnothing}$) und den vierten Knotenpunkt (N4) geschaltet ist.

6.   Differenzverstärker nach Anspruch 5, bei dem der Transistor (30) der zweiten Potentialfestlegungsschaltung ein n-Kanal FET ist.

7.   Differenzverstärker nach Anspruch 1, bei dem die Potentialermittlungsschaltung einen Inverter (32) umfaßt, der eine Eingangsklemme aufweist, die an den ersten Knotenpunkt (N1) gekoppelt ist, und eine Ausgangsklemme, die an die fünfte Steuerelektrode gekoppelt ist.

8.   Differenzverstärker nach Anspruch 5, der weiterhin umfaßt:

   einen achten Transistor (27), der zwischen den dritten Knotenpunkt (N3) und den sechsten Transistor (29) geschaltet ist, und der eine Steuerelektrode aufweist, an die ein Aktiv-Signal (∅) angelegt ist; und
   einen neunten Transistor (28), der zwischen den vierten Knotenpunkt (N4) und den siebten Transistor (30) geschaltet ist, und der eine Steuerelektrode aufweist, an die das Aktiv-Signal (∅) angelegt ist.

9.   Differenzverstärker nach Anspruch 8, bei dem der achte (27) und neunte (28) Transistor n-Kanal FETs sind.

10.   Differenzverstärker nach Anspruch 8, der weiterhin umfaßt:

   einen zehnten Transistor (21), der zwischen die erste Potentialquelle (V$_{cc}$) und den ersten Knotenpunkt (N1) geschaltet ist, und der eine Steuerelektrode aufweist, an die das Aktiv-Signal (∅) angelegt ist; und
   einen elften Transistor (22), der zwischen die erste Potentialquelle (V$_{cc}$) und den zweiten Knotenpunkt (N2) geschaltet ist, und der eine Steuerelektrode aufweist, an die das Aktiv-Signal (∅) angelegt ist.

11.   Differenzverstärker nach Anspruch 10, bei dem der zehnte (21) und elfte (22) Transistor p-Kanal FETs sind.

12.   Differenzverstärker nach Anspruch 10, der weiterhin umfaßt:

   einen zwölften Transistor (34; 44), der eine Steuerelektrode aufweist und zwischen die zweite Potentialquelle (V$_{ss}$;$\overline{\varnothing}$) und den vierten Knotenpunkt (N4) geschaltet ist; und
   eine weitere Potentialermittlungsschaltung, um das Potential des zweiten Knotenpunkts (N2) zu ermitteln und den zwölften Transistor (34; 44) leitend zu machen, wenn das Potential des zweiten Knotenpunkts (N2) kleiner ist als mittlere Potential des ersten Potentials (V$_{cc}$) und des zweiten Potentials (V$_{ss}$;$\overline{\varnothing}$).

13.   Differenzverstärker nach Anspruch 12, bei dem die weitere Potentialermittlungsschaltung einen Inverter (31) umfaßt, der eine Eingangsklemme aufweist, die an den zweiten Knoten gekoppelt ist, und eine Ausgangsklemme, die an die Steuerelektrode des zwölften Transistors (34; 44) gekoppelt ist.

14.   Differenzverstärker nach Anspruch 1 für eine integrierte Schaltung, dadurch gekennzeichnet, daß der erste (24) und zweite (23) Transistor kreuzgekoppelte p-Kanal Transistoren sind und daß der dritte (25) und vierte (26) Transistor kreuzgekoppelte n-Kanal Transistoren sind, von denen jeder einen jeweiligen Pfad mit regelbarer Leitfähigkeit und eine Steuerelektrode aufweist und Teil eines Flip-Flop (20) ist, wobei der erste und zweite Knotenpunkt innerhalb des Flip-Flops Ausgabesignale vom Differenzverstärker liefern.

15.   Verstärker nach Anspruch 14, bei dem die Potentialermittlungsschaltung folgendes einschließt:

   einen Inverter (32), der eine Eingangsklemme aufweist, die an den ersten Knotenpunkt gekoppelt ist, und
   eine Ausgangsklemme, die an die fünfte Steuerelektrode gekoppelt ist.

**16.** Verstärker nach Anspruch 14, der weiterhin eine zweite Spannungsermittlungsschaltung umfaßt, die an den zweiten Knotenpunkt (N2) gekoppelt ist.

**17.** Verstärker nach Anspruch 14, der weiterhin einschließt:

einen dritten (21) und vierten (22) p-Kanal Transistor, wobei der dritte p-Kanal Transistor (21) zwischen die erste Potentialquelle ($V_{cc}$) und den ersten Knotenpunkt (N1) geschaltet ist, und der vierte p-Kanal Transistor (22) zwischen die erste Potentialquelle und den zweiten Knotenpunkt (N2) geschaltet ist; eine Eingangsklemme, die zur Aufnahme eines Aktiv-Steuersignals (∅) geschaltet ist, wobei die Eingangsklemme das Steuersignal an Steuerelektroden des dritten (21) und vierten (22) p-Kanal-Transistors koppelt.

**18.** Verstärker nach Anspruch 14, bei dem die erste Potentialermittlungsschaltung einen dritten n-Kanal Transistor (29) umfaßt, der eine Steuerelektrode aufweist, die an die erste Eingangsklemme ($A_{in}$) gekoppelt ist, an die das erste Eingabesignal angelegt ist, und bei dem die zweite Potentialermittlungsschaltung einen vierten n-Kanal Transistor (30) umfaßt, der eine Steuerelektrode aufweist, die an die zweite Eingangsklemme ($V_r$) gekoppelt ist, an die das zweite Eingabesignal angelegt ist.

**19.** Verstärker nach Anspruch 18, der weiterhin umfaßt:

einen fünften n-Kanal Transistor (27), der zwischen den dritten Knotenpunkt (N3) und die erste Potentialermittlungsschaltung geschaltet ist, und der eine Steuerelektrode aufweist, an die ein Aktiv-Signal (∅) angelegt ist; und einen sechsten n-Kanal Transistor (28), der zwischen den vierten Knotenpunkt (N4) und die zweite Potentialermittlungsschaltung gekoppelt ist, und der eine Steuerelektrode aufweist, an die das Aktiv-Signal (∅) angelegt ist.

**20.** Differenzverstärker nach Anspruch 1, dadurch gekennzeichnet, daß

die Transistoren (23, 24, 25, 26) und zwei der Knotenpunkte (N1, N2) Teil eines Flip-Flops (20) sind; zwei Ausgangsklemmen ($\overline{A}$, A) jeweils an die Knotenpunkte (N1, N2) gekoppelt sind; und daß eine Pull-down-Schaltung reagierend zwischen die Potentialermittlungsschaltung und das Flip-Flop (20) geschaltet ist.

**21.** Verstärker nach Anspruch 20, der weiterhin einschließt:

eine Precharge-Schaltung, die ein Pull-up-Transistorenpaar aufweist und konfiguriert ist, ein Spannungspotential an den Knotenpunkten (N1, N2) in Reaktion auf ein Steuersignal aufzubauen.

**22.** Differenzverstärker nach Anspruch 12 für eine integrierte Schaltung, bei der die Potentialermittlungsschaltung einen Inverter (32) umfaßt, der eine Eingangsklemme aufweist, die an den ersten Knotenpunkt (N1) gekoppelt ist, und eine Ausgangsklemme, die an die fünfte Steuerelektrode gekoppelt ist.

**23.** Differenzverstärker nach Anspruch 22, bei dem die zweite Potentialermittlungsschaltung einen Inverter (31) umfaßt, der eine Eingangsklemme aufweist, die an den zweiten Knotenpunkt (N2) gekoppelt ist, und eine Ausgangsklemme, die an die Steuerelektrode des zwölften Transistors (34; 44) gekoppelt ist.

**Revendications**

**1.** Amplificateur différentiel comprenant :

un premier noeud (N1), un second noeud (N2), un troisième noeud (N3) et un quatrième noeud (N4); un premier transistor (24) ayant un premier type de conductivité et possédant une première électrode de commande couplée au premier noeud (N1), ledit premier transistor (24) étant branché entre le second noeud (N2) et une source d'un premier potentiel (Vcc); un second transistor (23) ayant le premier type de conductivité et possédant une seconde électrode de commande couplée au second noeud (N2), le second transistor (23) étant branché entre la source de premier potentiel (Vcc) et le premier noeud (N1); un troisième transistor (25) ayant un second type de conductivité et possédant une troisième électrode de commande couplée au second noeud (N2), le troisième transistor (25) étant branché entre le premier noeud (N1) et le troisième noeud (N3); un quatrième transistor (26) ayant le second type de conductivité et possédant une quatrième électrode de commande couplée au premier noeud (N1), le quatrième transistor (26) étant branché entre le second noeud (N2) et le quatrième noeud (N4); un premier circuit de définition de potentiel possédant une première borne d'entrée (Ain) et couplé au troisième noeud (N3), pour définir un potentiel du premier noeud (N1) en réponse à un signal appliqué à la première borne d'entrée (Ain);

un second circuit de définition de potentiel possédant une seconde borne d'entrée (Vr) et couplé au quatrième noeud (N4) pour définir un potentiel du second noeud (N2) en réponse à un signal appliqué à la seconde borne d'entrée (Vr);

un cinquième transistor (33;43) possédant une cinquième électrode de commande et couplé à une source d'un second potentiel (Vss;$\overline{\phi}$) et au troisième noeud (N3); et

un circuit de détection de potentiel pour détecter le potentiel du premier noeud (N1) et placer le premier transistor (33;43) à l'état conducteur lorsque le potentiel du premier noeud (N1) est inférieur à un potentiel médian compris entre le premier potentiel (Vcc) et le second potentiel (Vss;$\overline{\phi}$).

2. Amplificateur différentiel selon la revendication 1, dans lequel le premier transistor (24) et le second transistor (23) sont des FET à canal p et le troisième transistor (25) et le quatrième transistor (26) sont des FET à canal n.

3. Amplificateur différentiel selon la revendication 1, dans lequel le premier circuit de définition de potentiel comprend un sixième transistor (29) possédant une sixième électrode de commande couplée à la première borne d'entrée (Ain), le sixième transistor (29) étant branché entre la source de second potentiel (Vss;$\overline{\phi}$) et le troisième noeud (N3).

4. Amplificateur différentiel selon la revendication 3, dans lequel le sixième transistor (29) est un FET à canal n.

5. Amplificateur différentiel selon la revendication 3, dans lequel le second circuit de définition de potentiel comprend un septième transistor (30) possédant une électrode de commande couplée à la seconde borne d'entrée (Vr) et branché entre la source de second potentiel (Vss;$\overline{\phi}$) et le quatrième noeud (N4).

6. Amplificateur différentiel selon la revendication 5, dans lequel ledit transistor (30) dudit second circuit de définition de potentiel est un FET à canal n.

7. Amplificateur différentiel selon la revendication 1, dans lequel ledit circuit de détection de potentiel comprend un inverseur (32) possédant une borne d'entrée couplée au premier noeud (N1) et une borne de sortie couplée à la cinquième électrode de commande.

8. Amplificateur différentiel selon la revendication 5, comprenant en outre :

un huitième transistor (27) branché entre le troisième noeud (N3) et le sixième transistor (29) et possédant une électrode de commande, à laquelle est appliqué un signal actif ($\phi$); et

un neuvième transistor (28) branché entre le quatrième noeud (N4) et le septième transistor (30) et possédant une électrode de commande, à laquelle est appliqué le signal actif ($\phi$).

9. Amplificateur différentiel selon la revendication 8, dans lequel ledit huitième transistor (27) et ledit neuvième transistor (28) sont des FET à canal n.

10. Amplificateur différentiel selon la revendication 8, comprenant en outre :

un dixième transistor (21) branché entre la première source de potentiel (Vcc) et le premier noeud (N1) et possédant une électrode de commande, à laquelle est appliqué le signal actif ($\phi$);

un onzième transistor (22) branché entre la première source de premier potentiel (Vcc) et le second noeud (N2) et possédant une électrode de commande, à laquelle est appliqué le signal actif ($\phi$).

11. Amplificateur différentiel selon la revendication 10, dans lequel ledit dixième transistor (21) et ledit onzième transistor (22) sont des FET à canal p.

12. Amplificateur différentiel selon la revendication 10 comprenant en outre :

un douzième transistor (34;44) possédant une électrode de commande et branché entre ladite source de second potentiel (Vss;$\overline{\phi}$) et ledit quatrième noeud (N4); et

un autre circuit de détection de potentiel pour détecter le potentiel du second noeud (N2) et placer ledit douzième conducteur (34;44) à l'état conducteur lorsque le potentiel du second noeud (N2) est inférieur au potentiel médian entre le premier potentiel (Vcc) et le second potentiel (VSs;$\overline{\phi}$).

13. Amplificateur différentiel selon la revendication 12, dans lequel ledit autre circuit de définition de potentiel comprend un inverseur (31) possédant une borne d'entrée couplée au second noeud et une borne de sortie couplée à l'électrode de commande dudit douzième transistor (34;44).

14. Amplificateur différentiel selon la revendication 1 pour un circuit intégré, caractérisé en ce que

ledit premier transistor (24) et ledit second transistor (23) sont des transistors à canal p couplés selon un couplage croisé et que ledit troisième transistor (25) et ledit quatrième transistor (26) sont des transistors à canal n couplés selon un couplage croisé, chacun d'eux possédant un trajet respectif à conductivité commandable et une électrode de commande et faisant partie d'une bascule bistable (20), les premier et second noeuds à l'intérieur de ladite bascule bistable délivrant des signaux de sortie provenant de l'amplificateur différentiel.

15. Amplificateur selon la revendication 14, dans lequel ledit circuit de détection de potentiel comprend :

un inverseur (32) possédant une entrée couplée au premier noeud et une sortie couplée à la cinquième électrode de commande.

16. Amplificateur selon la revendication 14, comprenant en outre un second circuit de détection de tension couplé audit second noeud (N2).

17. Amplificateur selon la revendication 14, comprenant en outre :

un troisième transistor à canal p (21) et un quatrième transistor à canal p (22), le troisième transistor à canal p (21) étant branché entre ladite source de premier potentiel (Vcc) et le premier noeud (N1) et le quatrième transistor à canal p (22) étant branché entre ladite source de premier potentiel et le second noeud (N2); une entrée couplée de manière à recevoir un signal de commande actif ($\phi$), ladite entrée couplant ledit signal de commande à des électrodes de commande dudit troisième transistor à canal p (21) et dudit quatrième transistor à canal p (22).

18. Amplificateur selon la revendication 14, dans lequel le premier circuit de définition de potentiel comprend un troisième transistor à canal n (29) possédant une électrode de commande couplée à la première borne d'entrée (Ain), à laquelle est appliqué le premier signal d'entrée, et le second circuit de définition de potentiel comporte un quatrième transistor à canal n (30) possédant une électrode de commande couplée à la seconde borne d'entrée (Vr), à laquelle est appliqué le second signal d'entrée.

19. Amplificateur selon la revendication 18 comprenant en outre :

un cinquième transistor à canal n (27) branché entre le troisième noeud (N3) et ledit premier circuit de définition de potentiel et possédant une électrode de commande à laquelle est appliqué un signal actif ($\phi$) ; et un sixième transistor à canal n (28) branché entre le quatrième noeud (N4) et ledit second circuit de définition de potentiel et possédant une électrode de commande à laquelle le signal actif ($\phi$) est envoyé.

20. Amplificateur différentiel selon la revendication 1, caractérisé en ce que lesdits transistors (23,24, 25,26) et un couple desdits noeuds (N1,N2) font partie d'une bascule bistable (20); qu'un couple de bornes de sortie ($\overline{A}$,A) est couplé respectivement auxdits noeuds (N1,N2); et en ce qu'un circuit abaisseur de tension est branché, de manière à pouvoir répondre, entre ledit circuit de détection de potentiel et ladite bascule bistable (20).

21. Amplificateur selon la revendication 20, comprenant en outre :

un circuit de précharge comportant un couple de transistors élévateurs de tension et configuré de manière à accroître un potentiel de tension sur lesdits noeuds (N1,N2) en réponse à un signal de commande.

22. Amplificateur différentiel selon la revendication 12 pour un circuit intégré, dans lequel :

ledit circuit de détection de potentiel comprend un inverseur (32) possédant une borne d'entrée couplée audit premier noeud (N1) et une borne de sortie couplée à la cinquième électrode de commande.

23. Amplificateur différentiel selon la revendication 22, dans lequel ledit second circuit de détection de potentiel comprend un inverseur (31) possédant une borne d'entrée couplée au second noeud (N2) et possédant une borne de sortie couplée à l'électrode de commande du douzième transistor (34;44).

# Fig. 1

# Fig. 2

# Fig. 3

Potential

$\overline{A}$  A  Vr  Ain  $\phi 1$  $\phi 2$  time

# Fig. 4

Potential

$\overline{A}$  A  N5  Vr  $\phi$  Ain  time

EP 0 407 591 B1

# Fig. 5

# Fig. 6

Potential

time

13